**Europäisches Patentamt**

**European Patent Office**

**Office européen des brevets**

(19)

(11) Numéro de publication : **0 018 921**
**B1**

(12) FASCICULE DE BREVET EUROPÉEN

(45) Date de publication du fascicule du brevet :
29.02.84

(21) Numéro de dépôt : 80400614.6

(22) Date de dépôt : 06.05.80

(51) Int. Cl.³ : **H 01 F 31/00**, H 02 G 3/22,
G 01 R 15/02

(54) Dispositif de transmission électrique par un système de connexion amovible sans contact.

(30) Priorité : 07.05.79 FR 7911469

(43) Date de publication de la demande :
12.11.80 Bulletin 80/23

(45) Mention de la délivrance du brevet :
29.02.84 Bulletin 84/09

(84) Etats contractants désignés :
BE CH DE GB IT LI

(56) Documents cités :
DE-A- 2 429 049
DE-A- 2 543 828
FR-A- 671 744
FR-A- 952 243
FR-A- 1 303 365
GB-A- 497 075
GB-A- 1 099 866
GB-A- 1 199 256
US-A- 2 413 195
US-A- 3 667 342
US-A- 3 742 408
US-A- 3 793 166

(73) Titulaire : **COMMISSARIAT A L'ENERGIE ATOMIQUE**
**Etablissement de Caractère Scientifique Technique**
**et Industriel**
**B.P. 510**
**F-75752 Paris Cedex 15 (FR)**

(72) Inventeur : **Ricaud, Jean-Louis**
**39, Boulevard du Maréchal Joffre**
**F-92340 Bourg la Reine (FR)**
Inventeur : **Briez, Pierre René**
**3, rue Victor Hugo**
**78330 Fontenay le Fleury (FR)**
Inventeur : **Sajot, Pierre**
**29, Résidence du Parc**
**F-78650 Beynes (FR)**

(74) Mandataire : **Mongrédien, André et al**
**c/o BREVATOME 25, rue de Ponthieu**
**F-75008 Paris (FR)**

Dispositif de transmission électrique par un système de connexion amovible sans contact

Dans de nombreuses applications, il est souhaitable de pouvoir disposer de systèmes de raccordement amovibles ne présentant aucun risque d'établissement d'un courant électrique par contact manuel. Il est également souhaitable de pouvoir disposer de systèmes de raccordement dont le branchement ne donne lieu à l'établissement d'aucun arc électrique, notamment lorsque ces systèmes sont utilisés en milieu déflagrant ou dans les mines.

En outre, dans certaines applications particulières, et notamment lorsqu'on est en présence de produits dangereux, ces produits doivent être disposés à l'intérieur d'une cellule étanche ou derrière une paroi étanche et manipulés à distance au travers des parois. Au cours de ces différentes manipulations, un certain nombre de dispositifs et d'appareillages qui se trouvent derrière la paroi ou à l'intérieur de la cellule sont commandés électriquement, et les résultats de mesures effectuées sur ces produits doivent être communiqués à des appareils de lecture ou d'enregistrement situés à l'extérieur. La transmission de l'énergie électrique disponible à l'extérieur de la cellule vers des appareils situés à l'intérieur de celle-ci, ainsi que la communication vers l'extérieur de la cellule d'informations telles que les résultats de mesures effectuées à l'intérieur posent différents problèmes. Il s'agit tout d'abord de problèmes d'étanchéité au niveau de la traversée des parois par les fils ou les câbles électriques généralement utilisés. Il s'agit également de problèmes posés par le branchement à distance des appareils utilisés à l'intérieur de la cellule sur des prises de courant classiques au moyen de manipulateurs. Il s'agit enfin de problèmes posés par la corrosion des parties de câbles ou de fils et des prises de courant situées à l'intérieur de la cellule lorsque les produits manipulés sont particulièrement agressifs.

Il est connu dans l'état de la technique, illustré par la publication US-A-3 742 408, un dispositif de transmission d'un courant électrique comprenant deux transformateurs, une spire constituant à la fois le secondaire de l'un des transformateurs et le primaire de l'autre.

Par ailleurs, il est connu notamment du document GB-A-1 099 866 de faire traverser une paroi séparant deux transformateurs par une boucle électrique comportant le secondaire du premier transformateur et le primaire du deuxième transformateur.

Il est également connu, par exemple du document DE-A-2 543 828, de prélever un courant de mesure par un transformateur dont le secondaire est disposé dans une pince.

Toutefois, aucun de ces documents ne suggère une solution évidente au problème de la transmission d'un courant électrique au travers d'une paroi d'une cellule de confinement étanche, tel qu'il a été exposé précédemment.

La présente invention a pour objet un dispositif de transmission électrique ne présentant pas les inconvénients des dispositifs antérieurs, c'est-à-dire qu'il évite tout risque d'établissement d'un courant électrique lorsqu'il est débranché, et tout risque d'apparition d'un arc électrique au niveau du connecteur. En outre, lorsqu'il est utilisé pour manipuler des produits dangereux, il permet une traversée parfaitement étanche des parois de la cellule, autorise un branchement à distance des appareils contenus dans la cellule particulièrement simple et comprend des parties traversant la paroi non sensibles à la corrosion. Enfin, ce dispositif est particulièrement simple et fiable et, dans plusieurs de ses réalisations, il permet le démontage des pièces d'usure sans rupture de l'étanchéité.

Dans ce but, il est proposé conformément à l'invention un dispositif de transmission d'un courant électrique au travers d'une paroi d'une cellule de confinement étanche, comprenant un transformateur d'alimentation et au moins un transformateur de distribution, ces transformateurs ayant un enroulement commun constitué par au moins une spire qui définit le secondaire du transformateur d'alimentation et le primaire du transformateur de distribution, caractérisé en ce que les transformateurs d'alimentation et de distribution sont disposés respectivement à l'extérieur et à l'intérieur de la cellule, la spire commune à ces transformateurs étant réalisée en une seule pièce rigide et traversant la paroi de façon étanche, sans rompre sa continuité, et en ce que le secondaire du transformateur de distribution est disposé dans une pince amovible comprenant une poignée susceptible d'être saisie par un appareil de manipulation à distance.

Conformément à un premier mode de réalisation de l'invention, la spire est fixée à la paroi de façon étanche. Cette fixation peut être réalisée par soudure de la spire sur la paroi, et notamment sur le blindage en acier inoxydable qui définit généralement la face interne de la paroi.

Conformément à un deuxième mode de réalisation, la spire est reçue, à l'intérieur de la cellule, dans une excroissance tubulaire de la paroi reliée de façon étanche à cette dernière par ses deux extrémités, de telle sorte que l'intérieur de l'excroissance communique avec l'extérieur de la cellule. Comme dans la première variante, la fixation étanche de l'excroissance tubulaire sur la paroi est réalisée de préférence par soudure de la gaine sur la paroi, et notamment sur le blindage définissant la face interne de celle-ci.

Conformément à une autre caractéristique de l'invention, la pince amovible porte des galets susceptibles de rouler sur des surfaces de came appropriées pour commander l'ouverture et la fermeture de la pince lorsque celle-ci se déplace selon une direction déterminée. Selon une première variante, les galets sont alors montés aux extrémités des mors de la pince, les surfaces de came étant constituées par les surfaces externes de la spire ou d'une gaine entourant la spire. Selon une deuxième variante, les galets sont montés sur des bras solidaires des mors de la pince amovible, les surfaces de came étant formées sur un organe rapporté.

Selon une autre caractéristique de l'invention, la pince amovible est associée à un organe mobile en translation dans une direction parallèle à l'axe de la spire et/ou mobile en rotation autour de cet axe. Une telle structure peut permettre notamment de commander les déplacements d'un chariot, d'une porte guillotine ou d'une porte.

Selon encore une autre caractéristique de l'invention, lorsque le dispositif est destiné à transmettre un courant électrique triphasé, il comprend trois spires permettant de transmettre les trois phases du courant électrique. Cette structure particulière permet de transmettre l'énergie électrique nécessaire à la mise en œuvre d'un appareil alimenté en courant triphasé.

On décrira maintenant, à titre d'exemple non limitatif, un mode de réalisation particulier de l'invention en se référant aux dessins annexés dans lesquels :

la figure 1 est une vue en perspective d'un dispositif de transmission de courants électriques au travers d'une paroi étanche,

la figure 2 est une vue en perspective représentant une variante de réalisation du dispositif de la figure 1, et notamment de la pince dans laquelle est logé le secondaire du transformateur de distribution,

les figures 3 et 4 représentent une autre variante de la pince, respectivement en cours de montage et après montage, et

la figure 5 est une vue en perspective illustrant une application du dispositif selon l'invention à la transmission d'un courant triphasé.

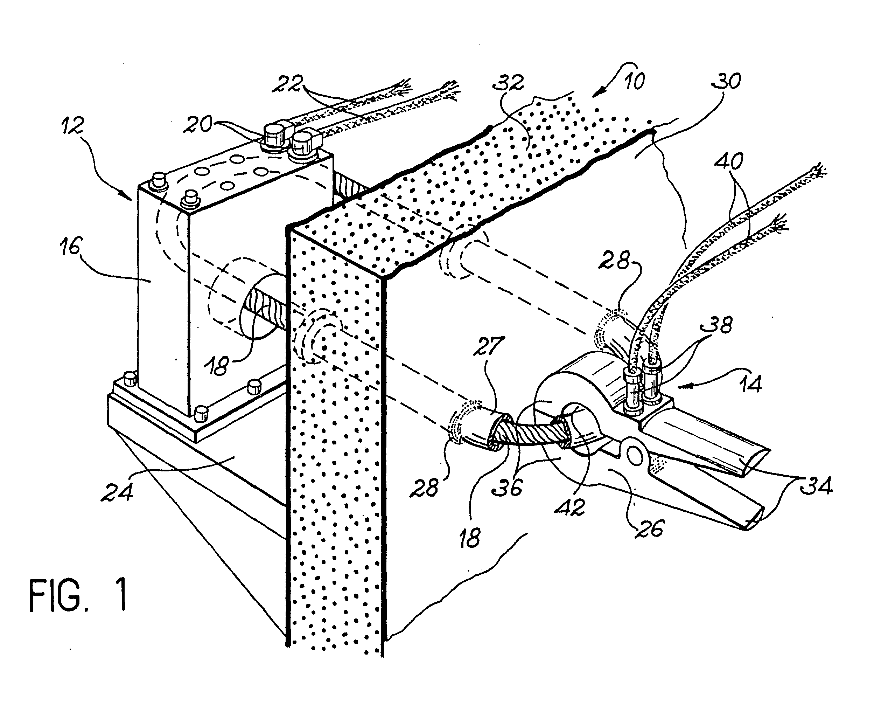

Sur la figure 1, on a représenté en vue éclatée une paroi 10, telle que l'une des parois d'une cellule destinée à recevoir des produits dangereux, par exemple des produits explosifs. Différents appareils (non représentés), destinés à la manipulation de ces produits, à la détection de certains phénomènes et à la réalisation de mesures de toutes sortes sont également disposés à l'intérieur de la cellule. Ces appareils peuvent être par exemple des vérins, des chariots, des portes, des relais, ainsi que des appareils de mesure et de contrôle de toutes sortes. Ils sont généralement commandés au moyen d'une énergie électrique provenant de l'extérieur de la cellule, et pour les appareils de mesure et de contrôle, doivent transmettre certaines informations à des systèmes de lecture ou d'enregistrement situés à l'extérieur de la cellule. Certains de ces appareils doivent également recevoir des signaux de commande émis à l'extérieur de la cellule. En outre, en raison de l'atmosphère régnant à l'intérieur de la cellule, il n'est pas possible de pénétrer à l'intérieur de celle-ci, de telle sorte que toutes les manipulations doivent être effectuées à distance, par exemple au moyen de manipulateurs traversant également les parois de la cellule. En particulier, les branchements électriques des différents appareils disposés à l'intérieur de la cellule sont effectués à distance de cette façon.

Conformément à l'invention, la transmission des différents signaux électriques que constituent l'énergie d'alimentation des appareils et les informations fournies notamment par les appareils de mesure et de contrôle au travers de la paroi 10 s'effectue au moyen d'un dispositif comprenant un transformateur d'alimentation 12 disposé à l'extérieur de la cellule et un transformateur de distribution 14 disposé à l'intérieur de la cellule. Les transformateurs 12 et 14 peuvent être soit des transformateurs de courant, soit des transformateurs de tension selon le point de fonctionnement choisi sur la caractéristique en charge du dispositif. L'enroulement primaire et le noyau du transformateur 12 sont disposés dans un boîtier 16 et l'enroulement secondaire 18 de ce transformateur est constitué par une spire unique, réalisée de préférence à partir d'une barre, d'un tube ou encore de fils de cuivre torsadés. L'enroulement primaire du transformateur 12 est alimenté par une source de courant (non représentée) reliée électriquement aux sorties 20 de cet enroulement par l'intermédiaire de fils 22. Comme on le verra par la suite, les sorties 20 peuvent être reliées simultanément à des appareils de mesure, de lecture ou d'enregistrement (non représentés). Le boîtier 16 enfermant l'enroulement primaire et le noyau du transformateur 12 est porté par un plateau support 24 qui peut être fixé à la paroi 10 de la cellule.

Conformément à l'invention, la spire unique 18 qui constitue l'enroulement secondaire du transformateur 12 traverse de façon étanche la paroi 10 de façon à constituer l'enroulement primaire du transformateur 14. L'enroulement secondaire ainsi que le noyau du transformateur 14 sont disposés à l'intérieur d'un organe amovible tel qu'une pince 26 prévue pour être montée et démontée à distance au moyen d'un manipulateur classique. La pince 26 est une pince ampèremétrique dont le principe est bien connu dans la technique.

Dans le mode de réalisation représenté sur la figure 1, la partie de la spire de cuivre 18 disposée à l'intérieur de la cellule est reçue dans une gaine 27 fixée de façon étanche par des soudures 28 au blindage interne 30 de la paroi 10, dont la partie principale 32 est constituée par une couche de plomb. La gaine 27 constitue ainsi une excroissance tubulaire de la paroi 10 dans la cellule. Cette structure permet d'obtenir une étanchéité parfaite entre l'intérieur et l'extérieur de la cellule délimitée par la paroi 10. De plus, et comme l'illustre clairement la figure 1, la gaine 27 constitue une excroissance de la paroi 10, et, plus précisément, de son blindage interne 30, à l'intérieur de la cellule, de telle sorte que la spire 18 ne pénètre pas réellement à l'intérieur de la cellule bien qu'elle traverse la paroi 10 de celle-ci. Cette caractéristique, essentielle lorsque le dispositif selon l'invention est destiné à transmettre un courant électrique au travers de la paroi d'une cellule dans laquelle sont manipulés des produits dangereux, permet de transmettre ce courant sans que la paroi ne présente aucune discontinuité. Ceci permet notamment de n'utiliser aucun joint ou autre pièce d'usure non démontable au niveau de la traversée de la paroi par la spire. Il en résulte que toutes les pièces d'usure du système de connexion et aussi la spire 18, peuvent être facilement démontées sans rupture de l'étanchéité de la cellule.

De préférence, la gaine 27 et le blindage interne 30 de la paroi 10 sont réalisés en acier inoxydable, ce qui permet de limiter les pertes dues aux courants de Foucault. En outre, la spire 18 peut éventuellement être recouverte d'isolant.

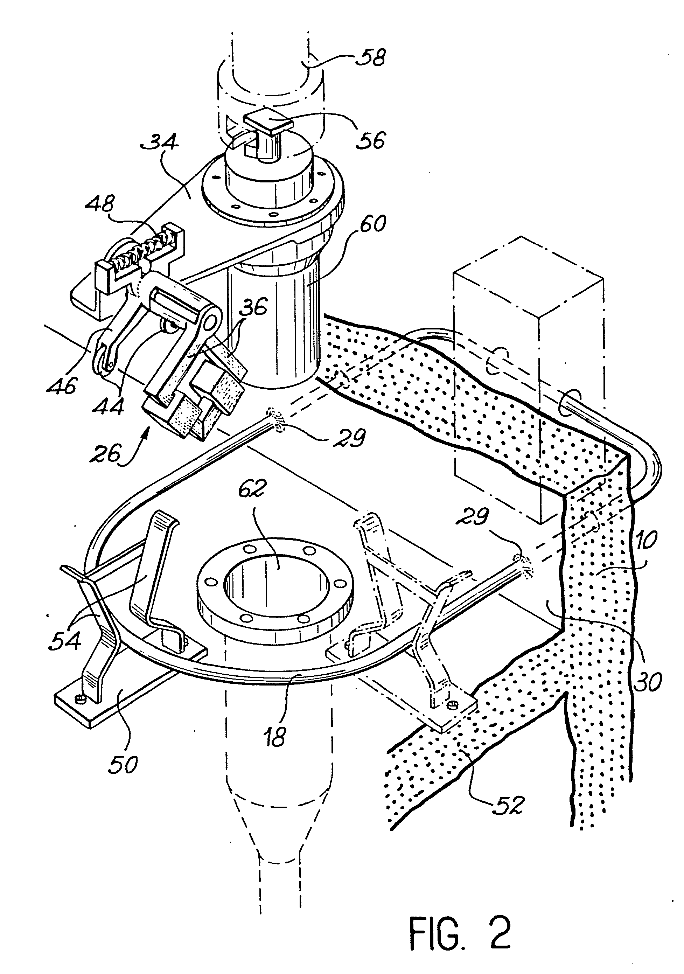

Dans un autre mode de réalisation, représenté sur la figure 2, la spire de cuivre 18 est fixée de façon étanche à la paroi 10 aux points de traversée par des soudures 29 réalisées directement entre la spire 18 et le blindage interne 30, de la paroi 10. Comme dans le mode de réalisation précédent, l'étanchéité entre l'intérieur et l'extérieur de la cellule est ainsi parfaitement assurée. Ce blindage 30 constitue un shunt pour la spire 18. Cependant, étant donné que la résistivité du blindage est beaucoup plus grande que celle de la spire, le shunt ne dérive qu'une petite partie du courant.

La pince 26 comprend une poignée 34 dont la forme est conçue de façon à pouvoir être saisie à distance par un manipulateur et deux mors 36 dans lesquels sont logés l'enroulement secondaire et le noyau du transformateur 14. La pince 26 comprend également deux sorties 38 par lesquelles l'enroulement secondaire du transformateur est relié électriquement au moyen de fils 40 à au moins l'un des instruments disposés à l'intérieur de la cellule. Lorsque la pince 26 est fermée comme le montre la figure 1, les extrémités des mors 36 se touchent et le flux magnétique généré dans le noyau du transformateur 14 est fermé lorsque la spire 18 se trouve située dans un espace annulaire 42 défini entre les mors 36.

Comme le montre la figure 1, la spire 18 peut être reçue avec un jeu relativement important dans l'espace 42, ce qui facilite le montage à distance de la pince 26. Afin de faciliter encore le montage et le démontage de la pince, dans une variante de réalisation de la pince 26 représentée sur la figure 2, des galets 44 sont montés tournants sur des bras 46 solidaires des mors 36 de la pince, celle-ci étant sollicitée en position fermée par un ressort 48. En outre, un organe 50, fixé à une autre paroi 52 de la cellule, définit deux surfaces de came en vis-à-vis 54, symétriques selon un plan passant par l'axe de la spire 18, sur lesquels viennent rouler les galets 44 lorsque la pince se déplace perpendiculaire au plan défini par la spire et contenu dans le plan de symétrie des surfaces de came. Les surfaces de came 54 sont conçues et disposées de telles sorte que la pince 26 s'ouvre lorsqu'elle passe au niveau de la spire 18, puis se referme autour de celle-ci.

Dans la variante de réalisation représentée sur la figure 2, la poignée 34 de la pince 26 comprend une queue d'aronde 56 susceptible d'être reçue dans une rainure correspondante formée à l'extrémité d'un bras de manipulateur 58 représenté en traits mixtes. La poignée 34 comprend de plus un piston de guidage 60 prolongeant le bras 58, et prévu pour être reçu dans un cylindre 62 ménagé dans la paroi 52, de façon à guider le bras 58 dans son déplacement selon un axe vertical dans la variante représentée, afin que les galets 44 restent en vis-à-vis des surfaces de came 54.

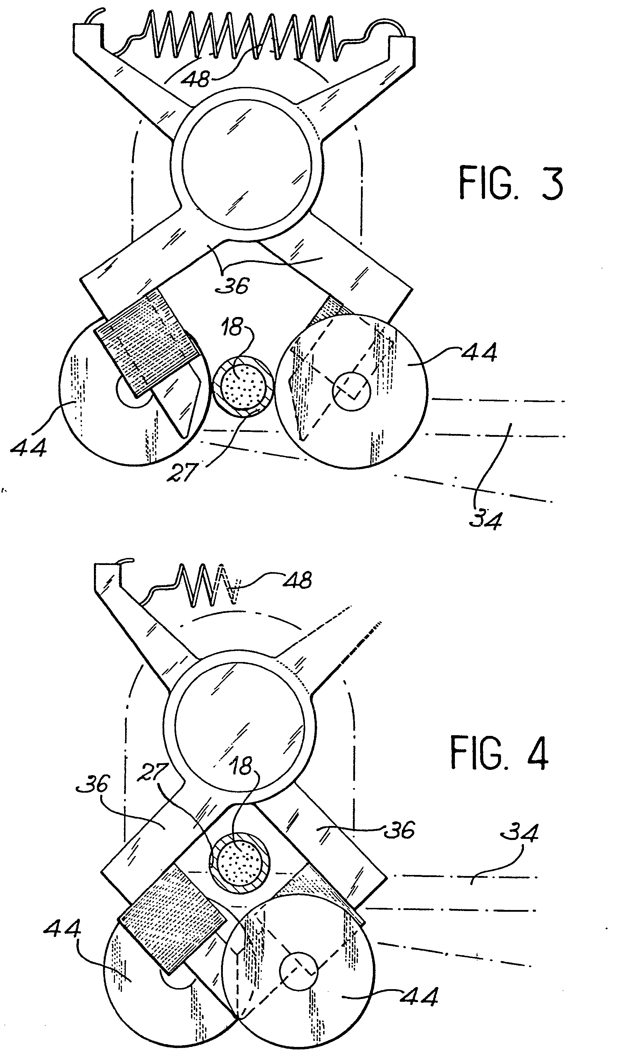

Dans une autre variante de réalisation de l'invention représentée sur les figures 3 et 4, les galets 44 sont montés directement sur les mors 36, de façon à venir en contact avec la surface externe de la gaine 27 avant l'extrémité des mors. Un ressort 48 sollicite également la pince en position de fermeture. Le montage et le démontage de la pince s'effectuent comme dans la variante représentée sur la figure 2 en déplaçant la pince selon un axe perpendiculaire au plan de la spire 18 et passant par l'axe de celle-ci. La pince est représentée en cours de montage ou de démontage sur la figure 3, alors que les galets 44 sont en contact avec la surface externe de la gaine, et en position de fonctionnement sur la figure 4, les extrémités des mors 36 étant en contact l'une avec l'autre.

On remarque que les galets sont décalés l'un par rapport à l'autre de façon à permettre leur chevauchement.

Dans les deux variantes de réalisation qui viennent d'être décrites en se référant aux figures 2 et 3, 4, la coopération des galets 44 avec les surfaces de came 54 ou avec les surfaces de came que définit la surface externe de la gaine 27 permet de réaliser le montage et le démontage à distance de la pince, par exemple au moyen d'un manipulateur, sans endommager les extrémités des mors 36 de la pince.

Par ailleurs, et comme illustré en traits mixtes sur la figure 2, plusieurs pinces 26 peuvent être montées sur une même spire 18, par exemple au moyen des surfaces de came formées sur au moins un second organe identique à l'organe 50.

En outre, la forme et l'orientation de la spire 18 peuvent être adaptées en fonction de l'application envisagée, de façon à permettre le déplacement des pinces 26 par rapport à la spire 18.

Ainsi, la spire 18 peut être disposée dans un plan horizontal et présenter à l'intérieur de la cellule la forme d'un arc de cercle, comme l'illustre la figure 1. Une telle disposition peut permettre, par exemple, l'alimentation électrique d'un moteur commandant la rotation d'un bras ou la manœuvre d'une porte, ces derniers portant directement la ou les pinces 26.

La spire 18, toujours disposée dans un plan horizontal, peut également présenter à l'intérieur de la cellule une partie rectiligne le long de laquelle peut se déplacer la pince 26, celle-ci étant associée, par exemple, à un chariot susceptible de se déplacer sur des rails à l'intérieur de l'enceinte. Lorsque le déplacement du chariot est important, il peut porter un certain nombre de pinces du type de la pince 26, la spire 18 étant alors maintenue régulièrement par des supports et des mécanismes commandant automatiquement l'ouverture des pinces lorsqu'elles passent en vis-à-vis de ces supports.

Dans un autre mode de réalisation (non représenté) la spire est rectangulaire et disposée dans un plan sensiblement vertical, ce qui permet par exemple à la pince 26 d'être associée à une porte quillotine dont le moteur électrique commandant la mise en œuvre est alimenté par l'intermédiaire d'un dispositif selon l'invention.

Bien entendu, un grand nombre d'autres applications peuvent être envisagées et la forme et l'orientation de la spire 18 peuvent être modifiées en fonction de la direction de déplacement en translation et/ou en rotation du dispositif associé à la, ou aux pince(s) 26 et dont la mise en œuvre est commandée au moyen d'un système électrique alimenté en énergie électrique par le dispositif selon l'invention.

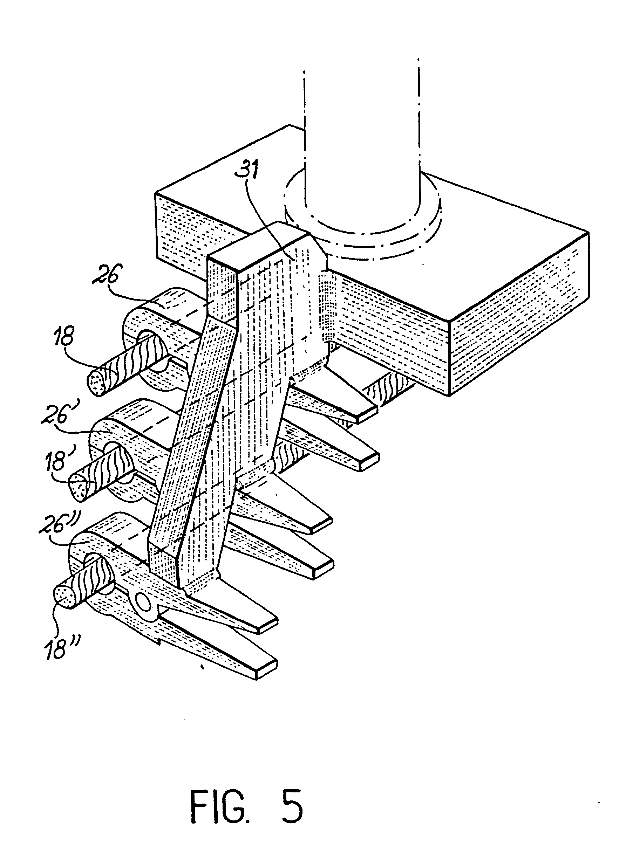

Enfin, dans un autre mode de réalisation représenté sur la figure 5, le dispositif selon l'invention est utilisé pour transmettre un courant électrique triphasé, destiné à l'alimentation d'un appareil triphasé. Dans ce cas, les transformateurs 12 et 14 sont des transformateurs triphasés, ce qui implique que le dispositif comprend trois spires 18, 18′ et 18″, de préférence de même forme, parallèles et disposées à égale distance les unes des autres. Lorsque l'appareil à alimenter est disposé à l'intérieur d'une cellule, ces spires traversent la paroi 10 de la même façon que la spire unique dans le mode de réalisation décrit précédemment. Ces spires reçoivent une ou plusieurs pinces 26, 26′, 26″ dont les mors définissent trois espaces destinés à recevoir chacun l'une des spires. Les pinces 26, 26′ et 26″ sont fixées par un support commun 31 à un dispositif commandé par un courant triphasé, tel qu'un chariot (non représenté).

Conformément à l'invention, la spire 18 et la pince 26 que l'on vient fixer sur cette partie jouent donc le même rôle qu'une prise de courant dans les dispositifs connus. En outre aucun courant électrique ne s'établit lorsqu'on touche la spire 18, de sorte que tout risque d'accident est évité. De plus, l'ouverture et la fermeture de la pince 26 ne donnent pas lieu à la suppression et à l'établissement d'un contact électrique, de telle sorte qu'aucun arc électrique ne peut se créer. Ceci permet d'utiliser le dispositif en milieu déflagrant ou dans les mines. En effet, la fermeture de la pince s'accompagne seulement de la fermeture d'un flux magnétique dans le noyau disposé à l'intérieur de la pince. De plus, le dispositif selon l'invention permet une manipulation à distance beaucoup plus facile que les prises de courant classiques. Enfin, il permet un remplacement aisé de toutes les pièces d'usure.

Le dispositif qui vient d'être décrit en se référant aux figures 1 à 5 fonctionne de la façon suivante.

Afin de transmettre à l'intérieur de la cellule délimitée par la paroi 10 la puissance électrique nécessaire à la mise en œuvre d'un ou de plusieurs appareils alimentés par les fils 40 branchés aux bornes 38 de l'enroulement secondaire logé dans la pince 26, les fils 22 sont raccordés à une source de courant (non représentée) alimentant l'enroulement primaire du transformateur 12. Sous l'effet du courant d'alimentation, et par l'intermédiaire des transformateurs 12 et 14, un courant électrique s'établit dans le circuit comprenant le ou les appareils (s) connecté (s) aux fils 40 et l'enroulement secondaire du transformateur 14. Les différents appareils disposés derrière la paroi 10 sont ainsi mis sous tension. A titre indicatif, le rendement d'un tel dispositif peut atteindre environ 0,5 lorsque la longueur de la spire 18 n'est pas trop importante et lorsque le jeu entre cette spire et les noyaux des transformateurs 12 et 14 reste limité. Une puissance d'environ 1 kW peut alors être transmise à un appareil situé à l'intérieur de la cellule délimitée par la cloison 10.

On remarquera que le dispositif selon l'invention assure un double isolement galvanique entre la source de courant connectée aux bornes 20 et l'appareil à alimenter raccordé aux bornes 38.

De même que le dispositif selon l'invention permet d'alimenter un ou plusieurs appareils disposés à l'intérieur de l'enceinte, il permet également de transmettre au travers de la paroi 10, dans l'un ou l'autre sens, des ordres et des informations codés. La transmission des ordres et des informations s'effectue par courant modulé, sous forme de fréquences discrètes ou de variations de fréquences superposées au courant d'alimentation. Ces informations codées peuvent être, par exemple, des résultats de mesure, ou encore des ordres de commande ou des informations de signalisations. La fréquence transmise peut atteindre environ 10 kHz, et la bande passante du dispositif selon l'invention est très large. La séparation des informations codées et du courant d'alimentation peut ensuite être effectuée de façon connue à l'aide de filtres ou de détecteurs synchrones avant que les informations codées ne soient transmises à des appareils de lecture directe ou à des enregistreurs.

Conformément à l'invention, on remarquera que seules la spire 18 lorsqu'elle est soudée à la paroi comme l'illustre la figure 2, et la gaine 27 lorsque la spire est reçue dans une gaine soudée à la paroi, comme l'illustre la figure 1, ne sont pas démontables. Ainsi, toutes les autres parties du dispositif, et en particulier les parties disposées à l'intérieur de la cellule, peuvent être changées sans nécessiter aucun démontage particulier lorsqu'elles sont usagées ou endommagées, par exemple lorsqu'une atmosphère particulièrement corrosive règne à l'intérieur de l'enceinte. Le dispositif selon l'invention est donc particulièrement sûr et fiable et se distingue également pour cette raison des dispositifs connus permettant de transmettre des signaux électriques.

On comprendra que l'invention n'est pas limitée aux modes de réalisation qui viennent d'être décrits à titre d'exemples, mais en incorpore toutes les variantes. Ainsi, le dispositif selon l'invention peut être utilisé dans tous les cas où une prise de courant est nécessaire, afin d'éviter tout risque d'accident ou d'explosion. En outre, on a déjà mentionné que la forme et l'orientation de la spire peuvent être modifiées en fonction de l'application envisagée. Enfin, le dispositif selon l'invention peut être utilisé dès que des signaux électriques doivent être transmis et quelle que soit la nature des produits manipulés à proximité du dispositif et la nature du milieu ambiant. Ainsi, ce dernier peut être aussi bien un gaz qu'un liquide, le dispositif selon l'invention pouvant être utilisé en milieu sous-marin ou aquatique.

## Revendications

1. Dispositif de transmission d'un courant électrique au travers d'une paroi (10) d'une cellule de confinement étanche, comprenant un transformateur d'alimentation (12) et au moins un transformateur de distribution (14), ces transformateurs ayant un enroulement commun constitué par au moins une spire (18) qui définit le secondaire du transformateur d'alimentation et le primaire du transformateur de distribution, caractérisé en ce que les transformateurs d'alimentation et de distribution sont disposés respectivement à l'extérieur et à l'intérieur de la cellule, la spire (18) commune à ces transformateurs étant réalisée en une seule pièce rigide et traversant la paroi (10) de façon étanche, sans rompre sa continuité, et en ce que le secondaire du transformateur de distribution est disposé dans une pièce amovible (26) comprenant une poignée (34) susceptible d'être saisie par un appareil de manipulation à distance.

2. Dispositif selon la revendication 1, caractérisé en ce que la spire (18) est fixée à la paroi de façon étanche aux points de traversée.

3. Dispositif selon la revendication 2, caractérisé en ce que la cloison comprend un blindage interne (30) et en ce que la spire (18) est soudée sur ce blindage.

4. Dispositif selon la revendication 1, caractérisé en ce que la spire (18) est reçue, à l'intérieur de la cellule, dans une excroissance tubulaire (27) de la paroi (10) reliée de façon étanche à cette dernière par ses deux extrémités, de telle sorte que l'intérieur de l'excroissance communique avec l'extérieur de la cellule.

5. Dispositif selon la revendication 4, caractérisé en ce que la cloison comprend un blindage interne (30) et en ce que ladite excroissance tubulaire (27) est soudée sur ce blindage.

6. Dispositif selon l'une quelconque des revendications 1 à 5, caractérisé en ce que la pince amovible (26) porte des galets (44) susceptibles de rouler sur des surfaces de came (54, 18) appropriées pour commander l'ouverture et la fermeture de la pince lorsque celle-ci se déplace selon une direction déterminée.

7. Dispositif selon la revendication 6, caractérisé en ce que les galets (44) sont montés aux extrémités des mors (36) de la pince amovible, les surfaces de came étant constituées par les surfaces externes de la spire (18) ou d'une gaine (27) entourant la spire.

8. Dispositif selon la revendication 6, caractérisé en ce que les galets (44) sont montés sur des bras (46) solidaires des mors (36) de la pince amovible, les surfaces de came (54) étant formées sur un organe rapporté.

9. Dispositif selon l'une quelconque des revendications 1 à 8, caractérisé en ce que la pince amovible (26) est associée à un organe mobile en translation dans une direction parallèle à l'axe de la spire et/ou mobile en rotation autour de cet axe.

10. Dispositif de transmission d'un courant électrique triphasé selon l'une quelconque des revendications 1 à 9, caractérisé en ce qu'il comprend trois spires (18, 18', 18'') permettant de transmettre les trois phases du courant électrique.

## Claims

1. A device for transmitting an electric current through a wall (10) of a leakproof confinement cell, comprising a supply transformer (12) and at least one distribution transformer (14), said transformers having a common winding comprising at least one turn (18) which forms the secondary of the supply transformer and the primary of the distribution transformer, characterised in that the supply and distribution transformers are arranged respectively outside and inside the cell, the turn (18) which is common to these transformers being produced as a single rigid component and passing through the wall (10) in a leakproof manner without breaking its continuity, and in that the secondary of the distribution transformer is arranged in a detachable component (26) comprising a handle (34) adapted for grasping a remote handling device.

2. A device according to Claim 1, characterised in that the turn (18) is fixed to the wall in a leakproof manner at the points of crossing.

3. A device according to Claim 2, characterised in that the enclosure comprises an internal armour (30) and in that the turn (18) is welded on this armour.

4. A device according to Claim 1, characterised in that the turn (18) is received, inside the cell, in a tubular protrusion (27) from the wall (10), connected to the latter in a leakproof manner by its two ends, whereby the interior of the protrusion communicates with the exterior of the cell.

5. A device according to Claim 4, characterised in that the enclosure comprises en internal armour (30) and in that the said tubular protrusion (27) is welded on this armour.

6. A device according to any one of Claims 1 to 5, characterised in that the detachable clamp (26) carries rollers (44) adapted for rolling on surfaces of suitable cams (54, 18) to control the opening and the closing of the clamp when the latter moves in a predetermined direction.

7. A device according to Claim 6, characterised in that the rollers (44) are mounted at the ends of the jaws (36) of the detachable clamp, the cam surfaces being formed by the external surfaces of the turn (18) or of a sleeve (27) surrounding the turn.

8. A device according to Claim 6, characterised in that the rollers (44) are mounted on arms (46) which are integral with the jaws (36) of the detachable clamp, the cam surfaces (54) being formed on a separate instrument.

9. A device according to any one of Claims 1 to 8, characterised in that the detachable clamp (26) is connected to an instrument which is movable in translation in a direction parallel to the axis of the turn and/or in rotatable around this axis.

10. A device for transmitting a three-phase electric current according to any one of Claims 1 to 9, characterised in that it comprises three turns (18, 18', 18'') permitting transmission of three phases of electric current.

**Ansprüche**

1. Vorrichtung zum Übertragen eines elektrischen Stromes quer durch eine Wand (10) einer dicht abgegrenzten Zelle, mit einem Speisetransformator (12) und wenigstens einem Verteilertransformator (14), wobei diese Transformatoren eine gemeinsame, von wenigstens einer Windung (18) gebildete Wicklung aufweist, welche die Sekundärwicklung des Speisetransformators und die Primärwicklung des Verteilertransformators bildet, dadurch gekennzeichnet, daß der Speise- und der Verteilertransformator außerhalb bzw. innerhalb der Zelle angeordnet sind, daß die gemeinsame Windung (18) dieser Transformatoren als ein einziges, steifes Teil ausgebildet ist und dicht durch die Wand (10) hindurchgeht, ohne deren Kontinuität zu unterbrechen und daß die Sekundärspule des Verteilertransformators in einem bewegbaren Teil (26) angeordnet ist, welches einen von einem Roboter ergreifbaren Griff (34) aufweist.

2. Vorrichtung nach Anspruch 1, dadurch gekennzeichnet, daß die Windung (18) dicht an der Wand an den zwei Durchquerungspunkten befestigt ist.

3. Vorrichtung nach Anspruch 2, dadurch gekennzeichnet, daß dei Wand eine innere Abschirmung (30) aufweist, und daß die Windung (18) an dieser Abschirmung angeschweißt ist.

4. Vorrichtung nach Anspruch 1, dadurch gekennzeichnet, daß die Windung (18) innerhalb der Zelle von einer rohrförmigen Ausstülpung (27) der Wand (10) aufgenommen ist, die dicht mit ihren zwei Enden mit der Wand derart verbunden ist, daß das Innere der Ausstülpung mit dem äußeren der Zelle in Verbindung steht.

5. Vorrichtung nach Anspruch 4, dadurch gekennzeichnet, daß die Wand eine Abschirmung (30) aufweist und daß die rohrförmige Ausstülpung (27) an der Abschirmung angeschweißt ist.

6. Vorrichtung nach irgendeinem der Ansprüche 1 bis 5, dadurch gekennzeichnet, daß die bewegbare Zange (26) Rollen (44) trägt, die auf geeigneten Kurvenflächen (54,18) abrollbar sind, um das Öffnen und das Schließen der Zange zu steuern, wenn diese sich in einer bestimmten Richtung bewegt.

7. Vorrichtung nach Anspruch 6, dadurch gekennzeichnet, daß die Rollen (44) an den Enden der Backen (36) der bewegbaren Zange befestigt sind und daß die Kurvenflächen von sich außerhalb der Windung (18) befindenden Flächen oder einer die Windung umgebenden Hülle (27) gebildet sind.

8. Vorrichtung nach Anspruch 6, dadurch gekennzeichnet, daß die Rollen (44) an den fest mit den Backen (36) der bewegbaren Zange verbundenen Armen (46) befestigt sind und daß die Kurvenflächen (54) an einem angebauten Teil ausgebildet sind.

9. Vorrichtung nach irgendeinem der Ansprüche 1 bis 8, dadurch gekennzeichnet, daß die bewegbare Zange (26) mit einem Organ verbunden ist, welches in einer zur Achse der Windung parallelen Richtung verschiebbar und/oder um diese Achse drehbewegbar ist.

10. Vorrichtung zum Übertragen eines elektrischen Dreiphasenstromes nach irgendeinem der Ansprüche 1 bis 9, dadurch gekennzeichnet, daß die Vorrichtung drei Windungen (18, 18', 18'') umfaßt, mit denen die drei Phasen des elektrischen Stromes übertragbar sind.

FIG. 1

FIG. 2

FIG. 3

FIG. 4

FIG. 5